(19) Europäisches Patentamt
European Patent Office
Office européen des brevets

(11) **EP 1 757 950 B1**

(12) **EUROPÄISCHE PATENTSCHRIFT**

(45) Veröffentlichungstag und Bekanntmachung des Hinweises auf die Patenterteilung:
**20.10.2010 Patentblatt 2010/42**

(51) Int Cl.:
***G01R 33/3815*** *(2006.01)*

(21) Anmeldenummer: **06016191.6**

(22) Anmeldetag: **03.08.2006**

(54) **Supraleitende Magnetanordnung mit kontaktierbaren Widerstandselementen**

Superconducting magnet assembly with contactable resistive elements

Assemblage d'aimants supraconducteurs avec des éléments résistifs pouvant être mis en contact

(84) Benannte Vertragsstaaten:
**CH FR GB LI**

(30) Priorität: **25.08.2005 DE 102005040374**

(43) Veröffentlichungstag der Anmeldung:
**28.02.2007 Patentblatt 2007/09**

(73) Patentinhaber: **Bruker BioSpin AG**
**8117 Fällanden (CH)**

(72) Erfinder:
• **Spreiter, Rolf**
**8050 Zürich (CH)**
• **Schauwecker, Robert**
**8004 Zürich (CH)**
• **Bovier, Pierre-Alain**
**8051 Zürich (CH)**

(74) Vertreter: **Kohler Schmid Möbus**
**Patentanwälte**
**Ruppmannstraße 27**
**70565 Stuttgart (DE)**

(56) Entgegenhaltungen:
DE-A1- 10 241 966    JP-A- 59 121 902
JP-A- 60 189 206    JP-A- 2000 077 226
US-B1- 6 307 370

EP 1 757 950 B1

## Beschreibung

Die Erfindung betrifft eine Magnetanordnung mit einem supraleitenden Magnetspulensystem und einem mindestens teilweise supraleitenden Strompfad, welcher mindestens Teile des Magnetspulensystems umfasst, wobei auf dem Strompfad mindestens zwei elektrische Anschlusspunkte angebracht sind, welche innerhalb des Strompfades mindestens einen Abschnitt begrenzen, so dass jeder Abschnitt von zwei aufeinanderfolgenden Anschlusspunkten begrenzt ist wobei der Abschnitt nicht die Gesamtheit der im Strompfad enthaltenen Teile des Magnetspulensystems umfasst, und mit mindestens einem fest verdrahteten Schutzelement, welches einen oder mehrere der Abschnitte parallel überbrückt und als Quenchschutz dient, wobei das supraleitende Magnetspulensystem im Betriebszustand ein Magnetfeld in Richtung einer z-Achse in einem auf der z-Achse um z=0 angeordneten Arbeitsvolumen erzeugt, und wobei zur Kompensation von Magnetfeldstörungen mindestens ein Widerstandselement mit einem elektrischen Widerstandswert größer oder gleich null einen oder mehrere der Abschnitte überbrückt.

Eine solche Magnetanordnung ist aus US 6'307'370 bekannt.

Magnetanordnungen mit einem in mehrere Abschnitte unterteilten supraleitenden Magnetspulensystem sind beispielsweise aus JP-A-59121902, US 6'369'464, US 6'777'938, JP-A-60189206, JP-A-2000077226 und DE-A-102 41 966 bekannt.

Supraleitende Magnetspulensysteme sind üblicherweise aus mehreren Teilspulen aufgebaut. Teilspulen, welche im Betriebszustand vom gleichen Magnetstrom durchflossen werden sollen, werden typischerweise in Serie zueinander geschaltet und bilden so einen einzigen supraleitenden Strompfad. Dies hat den Vorteil, dass die Teilspulen simultan mit einer einzigen Stromquelle geladen und entladen werden können, dass beim Laden und Entladen des Magnetspulensystems keine unerwünschten Stromdifferenzen zwischen den Teilspulen auftreten und dass die Ströme im Betriebszustand nicht aneinander angeglichen werden müssen.

Es gibt aber Fälle, in denen es vorteilhaft ist, die Serienschaltung der Teilspulen aufzuheben, indem an gewissen Stellen im Strompfad Verzweigungsmöglichkeiten über ein parallel geschaltetes elektrisches Schaltelement geschaffen werden. Die Anordnung gemäß US 6'307'370 stellt ein erstes Beispiel für ein Magnetspulensystem mit Verzweigungen im supraleitenden Strompfad dar. In dieser Anordnung ist der supraleitende Strompfad in Abschnitte unterteilt, welche mit Schutzwiderständen überbrückt sind. Im Falle eines plötzlichen Zusammenbruchs der Supraleitung in einer Teilspule (Quench) kann der Betriebsstrom aus diesem Abschnitt über das Schutzelement abfließen. So wird eine Beschädigung der Spule durch hohe elektrische Spannungen oder übermäßige Erhitzung verhindert.

Eine andere Situation, in der es vorteilhaft ist, dass der Strompfad des Magnetspulensystems Verzweigungsmöglichkeiten aufweist, ist eine Veränderung des magnetischen Umgebungsfeldes, in welches die Magnetanordnung eingebettet ist. Aufgrund des Prinzips der Erhaltung des magnetischen Flusses wird in dieser Situation in den supraleitenden Spulen der Magnetanordnung ein Strom induziert, welcher ein Gegenfeld zur Änderung des Umgebungsfeldes aufbaut. Wenn alle Teilspulen zu einem einzigen Strompfad zusammengeschlossen sind, ist es aber möglich, dass sich einzelne Teilspulen bei der Kompensation der Feldstörung gegenseitig behindern oder dass die Störung überkompensiert wird. Eine bessere Kompensation einer Störung im Umgebungsfeld wird erreicht, wenn die einzelnen Teilspulen der Magnetanordnung mit individuell verschiedenen Stromänderungen auf die Störung reagieren können. Dies wird beispielsweise bei einer Anordnung gemäß US 6'369'464 realisiert, wo ein Abschnitt des supraleitenden Strompfades des Magnetspulensystems durch einen supraleitenden Schalter überbrückt und kurzgeschlossen wird.

Die Verbesserung der Fähigkeit der Magnetanordnung, Feldstörungen zu kompensieren, ist auch Gegenstand von US 6'307'370. Abgesehen von ihrer primären Funktion als Quenchschutz-Elemente werden hier die Schutzwiderstände so angebracht und ausgelegt, dass sie im Falle einer Veränderung des Umgebungsfeldes zulassen, dass in verschiedenen Teilspulen unterschiedliche Kompensationsströme induziert werden können. Dadurch wird verhindert, dass sich einzelne Teilspulen bei der Kompensation der Feldstörung gegenseitig behindern oder dass die Störung überkompensiert wird. Im Gegensatz zu US 6'369'464 bauen sich aber die Differenzen der Kompensationsströme über die Schutzwiderstände mit der Zeit wieder ab.

Abgesehen von Quenchschutz und Störkompensation gibt es einen weiteren Fall, in welchem Verzweigungen im supraleitenden Strompfad des Magnetspulensystems vorteilhaft sind. Dieser Fall ist in US 6'777'938 beschrieben. Hier weist der supraleitende Strompfad eine resistive Fehlstelle auf, welche bewirkt, dass das Feld der Anordnung nicht stabil bleibt, wenn der Betriebsstrom nicht durch eine Stromquelle gestützt wird. Diesem Problem wird dadurch begegnet, dass ein nicht resistiver Abschnitt des Strompfades supraleitend kurzgeschlossen wird und mit dem resistiven Abschnitt eine induktive Kopplung aufweist. Während sich der leicht resistive Abschnitt langsam entlädt, wird der supraleitend kurzgeschlossene Abschnitt kontinuierlich induktiv geladen, wodurch das Gesamtfeld der Anordnung konstant gehalten werden kann (Driftkompensation).

Problematisch beim Anbringen von Verzweigungsmöglichkeiten im supraleitenden Strompfad eines Magnetspulensystems ist der Umstand, dass beim Laden und Entladen des Magnetspulensystems Ströme über die an den Verzweigungen kontaktierten elektrischen Bauteile fließen. Wenn die Widerstandswerte dieser Elemente klein sind, kann es sehr lange dauern, bis sich die Ströme in den Spulenabschnitten am Ende des Ladevorganges im Gleichgewicht befinden. Außerdem werden die den Spulenabschnitten parallel geschalteten Bauteile erhitzt. Dies ist problematisch, wenn sich die Bauteile im Kühlbehälter des Magnetsystems befinden. Weil supraleitende Magnetspulensysteme auf sehr tiefe Temperaturen von typischerweise wenigen Kelvin gekühlt werden müssen, ist das Abführen von zusätzlicher Wärmeleistung sehr aufwendig.

Aus diesem Grund dürfen beispielsweise die Widerstandswerte von fest mit dem supraleitenden Strompfad verbundenen Schutzwiderständen nicht zu klein sein. Wenn die Widerstandswerte zu hoch dimensioniert werden, können die Schutzwiderstände aber ihre Schutzfunktion im Falle eines Quenchs nicht mehr ideal wahrnehmen. Typischerweise sind Widerstandswerte in der Größenordnung von einem Ohm ein guter Kompromiss bei der Dimensionierung von Schutzwiderständen.

Wenn zur Kompensation einer Magnetdrift oder von magnetischen Störungen ein Teilabschnitt des supraleitenden Strompfades kurzgeschlossen werden soll, sind Widerstandswerte in der Größenordnung von einem Ohm zu groß. Für diese Anwendungen ist der Kurzschluss idealerweise sehr niederohmig oder supraleitend. Anstelle eines niederohmigen Widerstandselementes oder einer supraleitenden Verbindung werden diese Kurzschlüsse in Form eines supraleitenden Schalters ausgeführt. Durch Betätigen eines Heizers wird der Supraleiterdraht dieses Schalters beim Laden und Entladen der Magnetanordnung in den resistiven Zustand gebracht, so dass anstelle eines supraleitenden Kurzschlusses nun eine hochohmige Verbindung zwischen den Anschlusspunkten des supraleitenden Schalters besteht. So kann das Abfließen von Strom aus dem supraleitenden Strompfad des Magnetspulensystems beim Laden und Entladen teilweise verhindert werden. Allerdings wird durch das Beheizen des supraleitenden Schalters Wärme in den Kühlbehälter der Magnetanordnung gebracht, was zu unerwünschten Verlusten von Kühlmittel führt.

Aufgabe der vorliegenden Erfindung ist es, in einer Magnetanordnung mit einem supraleitenden Magnetspulensystem und einem supraleitenden Strompfad, welcher mindestens Teile des supraleitenden Magnetspulensystems umfasst, im supraleitenden Betriebszustand der Anordnung dem Strom im supraleitenden Strompfad Verzweigungsmöglichkeiten zur Verfügung zu stellen und gleichzeitig zu verhindern, dass beim Laden und Entladen der Magnetanordnung Ströme an diesen Verzweigungsstellen den supraleitenden Strompfad verlassen oder in ihn zurückfließen.

Diese Aufgabe wird erfindungsgemäß durch die Merkmale des kennzeichnenden Teils des Patentanspruchs 1 gelöst, insbesondere dadurch, dass mindestens zwei elektrische Kontakte, die im supraleitenden Zustand des Magnetspulensystems geschlossen und geöffnet werden können, vorgesehen sind, wobei jeweils ein elektrischer Kontakt eingangsseitig und ein elektrischer Kontakt ausgangsseitig bezüglich jedes Widerstandselements zwischen dem Widerstandselement und jeweils einem der mindestens zwei elektrischen Anschlusspunkten angeordnet ist.

Bei geschlossenem Kontakt sind die Widerstandselemente zu den Abschnitten des supraleitenden Strompfades, welche von den elektrischen Anschlusspunkten begrenzt werden, parallel geschaltet. Der Vorteil der erfindungsgemäßen Anordnung besteht darin, dass elektrische Bauteile, welche Abschnitte des supraleitenden Strompfades der Magnetspulenanordnung überbrücken, nur dann mit ihren Anschlusspunkten auf dem supraleitenden Strompfad kontaktiert sind, wenn ihre Funktionalität von Nutzen ist, aber nicht dann, wenn ihr Vorhandensein sich, beispielsweise auf den Lade- oder Entladevorgang des Magneten, nachteilig auswirken würde. So müssen keine Kompromisse bei der Abschnittsunterteilung und der Dimensionierung der Widerstandswerte der überbrückenden Bauteile eingegangen werden. Insbesondere können sehr niederohmige Bauteile eingesetzt werden ohne supraleitende Schalter verwenden zu müssen, was bei fest mit dem supraleitenden Strompfad des Magnetspulensystems kontaktierten Bauteilen nicht möglich wäre. Insgesamt kann so die Funktionalität der überbrückenden Bauteile (zur Kompensation von Magnetfeldstörungen, Driftkompensation, Spulenschutz im Quenchfall) verbessert werden und die Zeitdauer bis zum Erreichen des Gleichgewichtes der Ströme in den Spulenabschnitten nach dem Laden und Entladen sowie der Wärmeeintrag in den Kühlbehälter beim Laden und Entladen können eliminiert werden.

Falls kontaktierbare Widerstandselemente, beispielsweise zur Kompensation von Störungen der magnetischen Feldumgebung, eingesetzt werden, kann der Schutz des Magnetspulensystems im Falle eines Quenchs mit den zusätzlichen, fest verdrahteten Schutzelementen gewährleistet werden.

Erfindungsgemäß sind mindestens zwei der Anschlusspunkte innerhalb des Strompfades des Magnetspulensystems derart angeordnet sind, dass für die Größe

$$\beta(t) = 1 + \frac{b \cdot \Delta I(t)}{\Delta B_z}$$

im Falle von mindestens zwei geschlossenen Kontakten zwischen Anschlusspunkten auf dem Strompfad und Widerstandselementen, welche einen Widerstandswert größer oder gleich null aufweisen, zur Zeit $t=0$ ein Wert $\beta_{closed}(t = 0)$ resultiert, welcher im Betrag kleiner ist als die Größe $\beta_{open}(t = 0)$, welche zur Zeit $t=0$ und bei offenen Kontakten resultiert, mit

b: Vektor der Magnetfelder in Richtung der z-Achse jeder Windung des Magnetspulensystems im Arbeitsvolumen für jeweils 1 Ampere Strom,

$\Delta I(t)$: Vektor der Stromänderungen jeder Windung des Magnetspulensystems, welche durch eine Änderung $\Delta B_z$ des Magnetfeldes induziert werden, wobei $\Delta B_z$ die Komponente parallel zur z-Achse einer stufenförmigen Änderung des Magnetfeldhintergrundes im Zentrum der Magnetanordnung zur Zeit t=0 bedeutet.

Die Größe β entspricht dem Anteil einer Änderung des Umgebungsfeldes, welcher im Arbeitsvolumen der Magnetanordnung spürbar ist. Wenn β=1, dringt die Feldstörung unkompensiert ins Arbeitsvolumen ein. β=0 bedeutet vollständige Kompensation der Störung und β<0 entspricht einer Überkompensation der Störung durch das Magnetspulensystem, das heißt, der Vektor der Feldänderung im Arbeitsvolumen zeigt in die entgegengesetzte Richtung des Vektors der Änderung des Umgebungsfeldes.

Innerhalb eines supraleitenden Strompfades, in welchem mehrere Teilspulen eines Magnetspulensystems in Serie geschaltet sind, können sich einzelne Teilspulen bei der Kompensation der Feldstörung gegenseitig behindern oder die Störung kann überkompensiert werden, d.h. |β| ist wesentlich größer als null. Dies kann verhindert werden, wenn im Betriebszustand der Anordnung der supraleitende Strompfad in mehrere Abschnitte unterteilt wird, welche mit Widerstandselementen überbrückt sind und in welchen im Falle einer Feldstörung individuell verschiedene Kompensationsströme induziert werden können. Durch eine Erhöhung der Anzahl der Abschnitte wird die Anzahl der Freiheitsgrade für die Kompensationsströme erhöht, was typischerweise zu besseren Resultaten bei der Störkompensation führt, d.h. $|\beta_{closed}(t = 0)| < |\beta_{open}(t = 0)|$. Eine feine Unterteilung des Strompfades in resistiv überbrückte Abschnitte führt zu Problemen beim Laden und Entladen der Magnetanordnung, weshalb es besonders vorteilhaft ist, dass die Kontakte zwischen den Anschlusspunkten, welche die Abschnitte des supraleitenden Strompfades begrenzen, und den Widerstandselementen im supraleitenden Zustand der Magnetanordnung geöffnet und geschlossen werden können. Bei der erfindungsgemäßen Magnetanordnung kann also durch Schließen von Kontakten eine Schaltung aktiviert werden, welche die Magnetanordnung hinsichtlich ihrer Fähigkeit zur Kompensation von Störungen des Umgebungsfeldes optimiert.

Um das Verhalten einer Magnetanordnung beim Auftreten einer Störung des Umgebungsfeldes zu charakterisieren, ist es nützlich, eine stufenförmige Störung mit einem Feldsprung zur Zeit t=0 anzunehmen. Die Aufteilung des supraleitenden Strompfades des Magnetspulensystems in individuell mit Widerstandselementen kurzgeschlossene Abschnitte beeinflusst das Kompensationsverhalten zur Zeit t=0 der Magnetanordnung. Die Dimensionierung der Widerstandselemente beeinflusst das Kompensationsverhalten für Zeiten t>0. Falls alle Widerstandselemente einen Widerstandswert von 0 aufweisen (supraleitende Kurzschlüsse), bleiben die in den Abschnitten induzierten individuell verschiedenen Kompensationsströme für alle Zeiten erhalten und es ist $\beta_{closed}(t)=\beta_{closed}(t = 0)$ für alle t. Wenn alle Kontakte offen sind, ist $\beta_{open}(t) = \beta_{open}(t = 0) = \beta_{open}$ für alle t. Wenn die Widerstandswerte der Widerstandselemente strikt größer als 0 sind, werden sich die in den Abschnitten induzierten individuell verschiedenen Kompensationsströme mit der Zeit abbauen und es gilt:

$$\beta_{closed}(t) \to \beta_{open} \text{ für } t \to \infty.$$

Wenn aufgrund einer geeigneten Unterteilung des supraleitenden Strompfades des Magnetspulensystems erreicht wurde, dass $\beta_{closed}(t = 0) | < |\beta_{open}|$, ist es vorteilhaft, wenn die Zeitdauer, mit welcher sich $\beta_{closed}(t)$ dem Endwert $\beta_{open}$ angleicht, möglichst lange ist. Dann wird nämlich die magnetische Störung instantan gut kompensiert und dringt zeitlich stark gedämpft ins Arbeitsvolumen der Magnetanordnung ein. Außerdem ist es wichtig, dass sich $\beta_{closed}(t = 0)$ möglichst monoton dem Endwert $\beta_{open}$ annähert, dass also insbesondere kein Überschwingen auftritt. Aus diesen Gründen ist eine Ausführungsform der Erfindung besonders vorteilhaft, bei welcher die Widerstandselemente, welche die Abschnitte überbrücken, so dimensioniert sind, dass im Falle von mindestens zwei geschlossenen Kontakten zwischen Widerstandselementen und Anschlusspunkten, welche Abschnitte des supraleitenden Strompfades des Magnetspulensystems begrenzen, für alle Zeiten t der Wert $\beta_{closed}(t)$ im Betrag kleiner als oder gleich wie die Größe $\beta_{open}(t)$ ist, welche bei offenen Kontakten (K1, K2, K3, K4) resultiert. Dies wird typischerweise dadurch erreicht, dass die Widerstandswerte möglichst klein, vorzugsweise im Bereich von Milliohm, gewählt werden.

Um möglichst kleine Widerstandswerte zu erhalten, können die Widerstandselemente gekühlt werden. Daher ist eine Ausführungsform der erfindungsgemäßen Magnetanordnung besonders vorteilhaft, bei welcher die Widerstandselemente mit dem supraleitenden Magnetspulensystem gemeinsam in einer gekühlten Kammer angeordnet sind.

Vorzugsweise umfasst mindestens eines der fest verdrahteten Schutzelemente ohmsche Widerstandselemente oder Dioden, oder eine Kombination von beiden. Dioden haben den Vorteil, dass beim Laden und Entladen des Magnetsystems keine Wärme erzeugt wird und so der Kühlmittelverbrauch niedrig gehalten werden kann.

Fest verdrahtete Schutzwiderstände dürfen keinen zu kleinen Widerstand aufweisen, weil sonst Probleme beim Laden und Entladen der Magnetanordnung auftreten. Bei einer Störung der magnetischen Feldumgebung können die mit Schutzwiderständen überbrückten Spulenabschnitte zwar je mit einer individuell verschiedenen induzierten Stromänderung reagieren, die Differenzen zwischen den induzierten Strömen bauen sich jedoch über die Schutzwiderstände schnell wieder ab und die Störung dringt nur wenig verzögert ins Arbeitsvolumen der Magnetanordnung ein. Hinsichtlich der Dämpfung von Störungen der magnetischen Feldumgebung ist es daher besonders vorteilhaft, wenn im Betriebszustand der Magnetanordnung zusätzlich niederohmige Widerstandselemente über Abschnitten des supraleitenden Strompfades des Magnetspulensystems kontaktiert werden. Eine bevorzugte Ausführungsform der Erfindung sieht daher vor, dass die Widerstandselemente einen Widerstandswert aufweisen, der kleiner als der Widerstandswert der Schutzelemente ist.

Eine weitere vorteilhafte Ausführungsform der erfindungsgemäßen Magnetanordnung sieht vor, dass die Widerstandselemente Teil eines Steckers sind, und dass die Widerstandselemente durch Schließen der Kontakte mittels Einstecken des Steckers in seinen Gegenpol, aus dem die Anschlusspunkte herausgeführt sind, mit den Anschlusspunkten verbunden werden können. Je nach Betriebszustand können dadurch die zusätzlichen Widerstandselemente auf einfache Art und Weise zu- oder weggeschaltet werden. Diese Art der Kontaktierung erlaubt ein einfaches Austauschen der Widerstandselemente, wodurch beispielsweise die Fähigkeit der Magnetanordnung, Störungen im Umgebungsfeld zu kompensieren, im Betriebszustand experimentell optimiert werden kann. Außerdem ist bei Beschädigung der zusätzlichen Widerstandselemente bei einem Quench des Magnetspulensystems ein schnelles Ersetzen der Widerstandselemente möglich.

Ebenso ist es denkbar, dass die Widerstandselemente durch Schließen der Kontakte mittels Betätigen eines Schalters mit den Anschlusspunkten auf dem supraleitenden Strompfad verbunden werden können.

Eine bevorzugte Ausführungsform sieht vor, dass die Widerstandselemente mit zunehmendem Strom einen zunehmenden Widerstandswert aufweisen.

Im Falle eines Quenchs des supraleitenden Magnetspulensystems ist es vorteilhaft, wenn die Widerstandselemente hochohmig werden, insbesondere wenn sie einen Widerstandswert von mehr als 10 Ohm annehmen. Dann stellen die fest verdrahteten Schutzelemente den Schutz des Magnetspulensystems sicher, wenn diese Schutzelemente einen tieferen Widerstandswert aufweisen und daher den Magnetstrom aus den gequenchten Abschnitten anstelle der hochohmigen zugeschalteten Widerstandselemente übernehmen. Im Betriebszustand sind die Widerstandselemente niederohmig und bewirken eine gute zeitliche Dämpfung des Eindringens von Störungen in der Feldumgebung ins Arbeitsvolumen der Magnetanordnung. Im Quenchfall werden die Widerstandselemente hochohmig, wodurch diese Elemente, die Anschlusspunkte auf dem supraleitenden Strompfad, die Zuleitungen und die Kontakte im Quenchfall vor hohen Strömen geschützt sind.

Vorzugsweise sind die Widerstandselemente Sicherungselemente, die höchstens 20% des Magnetstromes tragen können, bevor sie durchbrennen und hochohmig werden, und dann einen Widerstandswert von mehr als 10 Ohm annehmen. Mit Sicherungen als zuschaltbaren Widerstandselementen, die bei einem gewissen Strom durchschmelzen, können die Anforderungen für optimale Kompensation von Störungen der Feldumgebung der Magnetanordnung optimal erfüllt werden. Im Betriebszustand sind die Widerstandselemente sehr niederohmig, beim Quench schmelzen sie durch und werden rasch sehr hochohmig. Dadurch werden die Anschlusspunkte auf dem supraleitenden Strompfad, die Zuleitungen und die Kontakte vor hohen Strömen geschützt.

Die Erfindung betrifft auch ein Verfahren zum Betrieb einer erfindungsgemäßen Magnetanordnung, welches vorsieht, dass mindestens einer der elektrischen Kontakte zwischen mindestens einem elektrischen Anschlusspunkten auf dem supraleitenden Strompfad des Magnetspulensystems und mindestens einem Widerstandselement im Betriebszustand des Magnetspulensystems geschlossen und beim Laden und Entladen des Magnetspulensystems geöffnet wird. Im Betriebszustand stellen die typischerweise sehr niederohmigen zuschaltbaren Widerstandselemente beispielsweise sicher, dass Störungen in der Feldumgebung der Magnetanordnung sich nur mit einer großen zeitlichen Verzögerung im Arbeitsvolumen auswirken. Beim Laden und Entladen der Magnetanordnung sind die niederohmigen Verbindungen unerwünscht und ihre Kontakte zum supraleitenden Strompfad werden unterbrochen, weil sie sonst beispielsweise zusätzliche Wärme im Kühlbehälter der Magnetanordnung generieren würden, oder weil sie die Dauer, bis die Ströme in den Abschnitten des Magnetspulensystems nach dem Laden im Gleichgewicht sind, verlängern würden. Wenn es sich bei den Widerstandselementen um Sicherungselemente handelt, könnten diese beim Laden / Entladen der Magnetanordnung durchschmelzen, was zu verhindern ist.

Bei diesem Verfahren zum Betrieb einer erfindungsgemäßen Magnetanordnung wird also zwischen zwei verschiedenen Zuständen geschaltet. Einer der Zustände ist optimiert für das Laden und Entladen des Magneten, der andere Zustand ist optimiert beispielsweise für die Kompensation von Störungen im Umgebungsfeld der Magnetanordnung. Es ist auch denkbar, dass im zweiten Zustand der Quenchschutz der Spule optimiert ist, oder dass eine Kompensation einer Felddrift des Magnetspulensystems erzielt wird.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1    eine Schaltung einer nicht beanspruchten Magnetanordnung mit kontaktier- baren Widerstandselementen;

Fig. 2    eine Schaltung einer erfindungsgemäße Magnetanordnung mit fest verdrah- teten Schutzelementen und zuschaltbaren Widerstandselementen;

Fig. 3    eine schematische Darstellung eines supraleitendes Magnetspulensystems mit einem Arbeitsvolumen;

Fig. 4    eine Schaltung einer erfindungsgemäße Magnetanordnung mit zwei auf- steckbaren Widerstandselementen;

Fig. 5    eine graphische Darstellung eines mit einer erfindungsgemäße Anordnung erreichbaren Faktors $\beta(t)$ in Ab- hängigkeit von der Zeit (Simulation) ;

Fig. 6    eine graphische Darstellung eines mit einer erfindungsgemäße Anordnung erreichbaren gegenüber Fig. 5 weiter verringerten Faktors $\beta(t)$ in Abhängig- keit von der Zeit (Simulation); und

Fig. 7    eine erfindungsgemäße Magnetanordnung mit einem Widerstandselement als Teil eines Steckers in einer Kühlkammer des Magnetspulensystems.

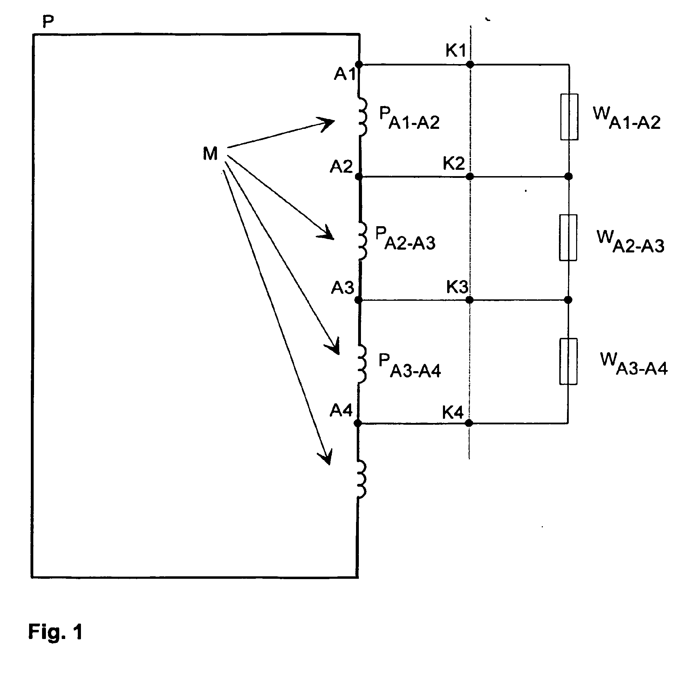

**Fig. 1** zeigt eine Anordnung mit einem Magnetspulensystem **M** mit drei Abschnitten $P_{A1\text{-}A2}$, $P_{A2\text{-}A3}$, $P_{A3\text{-}A4}$ in Form von Teilspulen, welche von Anschlusspunkten **A1, A2, A3, A4** begrenzt werden, und mit einem Strompfad **P**, der die Abschnitte $P_{A1\text{-}A2}$, $P_{A2\text{-}A3}$, $P_{A3\text{-}A4}$ umfasst.

Die Abschnitte $P_{A1\text{-}A2}$, $P_{A2\text{-}A3}$, $P_{A3\text{-}A4}$ können im Betriebszustand mit Widerstandselementen $W_{A1\text{-}A2}$, $W_{A2\text{-}A3}$, $W_{A3\text{-}A4}$ überbrückt werden. Zwischen den Widerstandselementen $W_{A1\text{-}A2}$, $W_{A2\text{-}A3}$, $W_{A3\text{-}A4}$ und den Anschlusspunkten A1, A2, A3, A4 sind Kontakte **K1, K2, K3, K4** vorgesehen, die im supraleitenden Zustand der Magnetanordnung geöffnet und geschlossen werden können. Bei geschlossenen Kontakten K1, K2, K3, K4 sind die Widerstandselemente $W_{A1\text{-}A2}$, $W_{A2\text{-}A3}$, $W_{A3\text{-}A4}$ an Anschlusspunkten A1, A2, A3, A4 parallel zu den Abschnitten $P_{A1\text{-}A2}$, $P_{A2\text{-}A3}$, $P_{A3\text{-}A4}$ geschaltet.

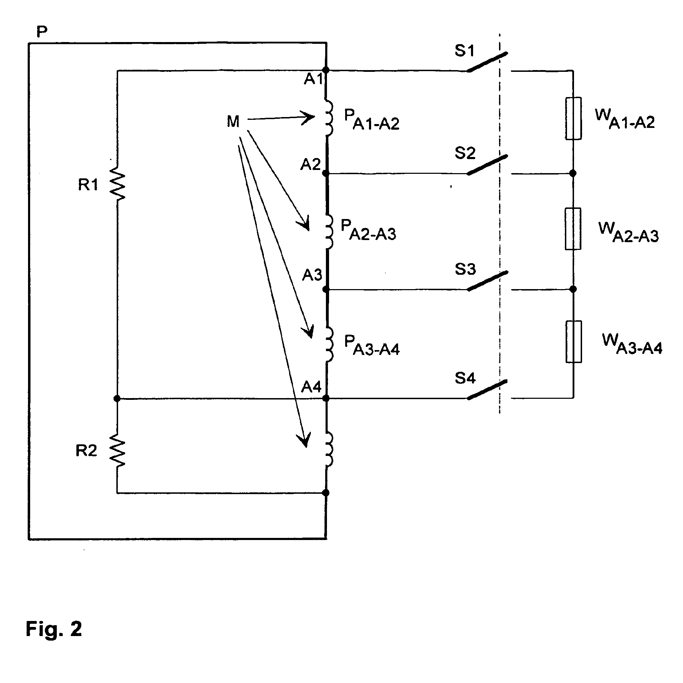

**Fig. 2** zeigt eine Ausführungsform der erfindungsgemäßen Anordnung, bei welcher die Kontakte K1, K2, K3, K4 durch Betätigen der Schalter **S1, S2, S3, S4** geschlossen und geöffnet werden können. Für den Quenchschutz der Magnetanordnung sind Schutzelemente **R1, R2** vorgesehen, die mit dem Magnetspulensystem M fest verdrahtet sind.

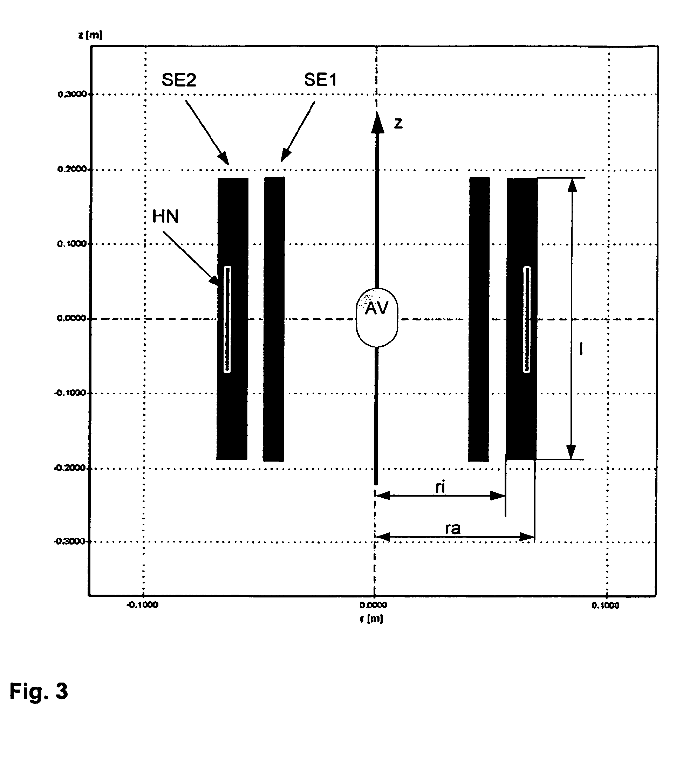

**Fig. 3** zeigt eine schematische Darstellung einer Ausführungsform einer erfindungsgemäßen supraleitenden Spulenanordnung in einer Schnittansicht. Zwei Sektionen **SE1** und **SE2** des Magnetspulensystems M, die als Solenoidspulen der Länge I ausgebildet sein können, sind im Abstand **ri** beziehungsweise **ra** von der Symmetrieachse **z** der Magnetanordnung konzentrisch zueinander angeordnet. Im magnetischen Zentrum befindet sich ein Arbeitsvolumen **AV,** in dem die z - Komponente des Magnetfeldes maximal ist und wo die zu untersuchende Probe platziert werden kann. Die äußere Sektion SE2 enthält einen Bereich mit halber Stromdichte, einen so genannten Halfnotch **HN,** dessen Zweck die Homogenisierung des Magnetfeldes im Arbeitsvolumen AV ist.

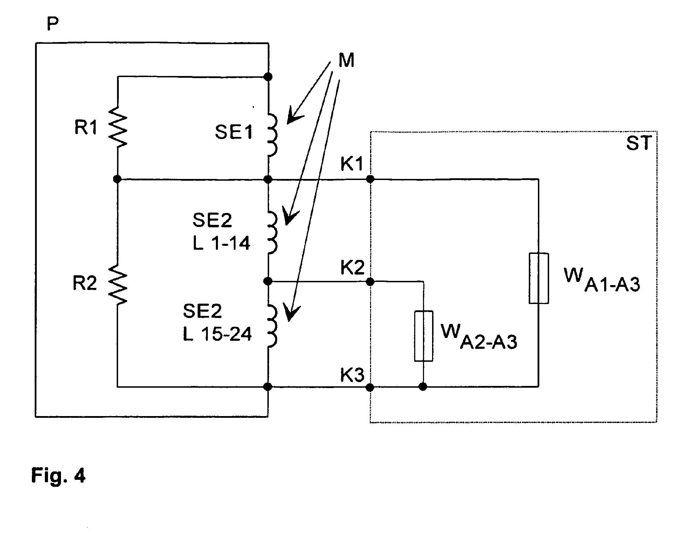

**Fig. 4** zeigt eine weitere Ausführungsform einer erfindungsgemäßen Magnetanordnung, bei der Spulenabschnitte **SE2L1-14, SE2LO15-24** der äußeren Sektion SE2 des Magnetspulensystem M aus Fig. 3 mit zwei Widerstand- selementen $W_{A1\text{-}A3}$, $W_{A2\text{-}A3}$ überbrückt werden können. Die Widerstandselemente $W_{A1\text{-}A3}$, $W_{A2\text{-}A3}$ sind in einem Stecker ST integriert.

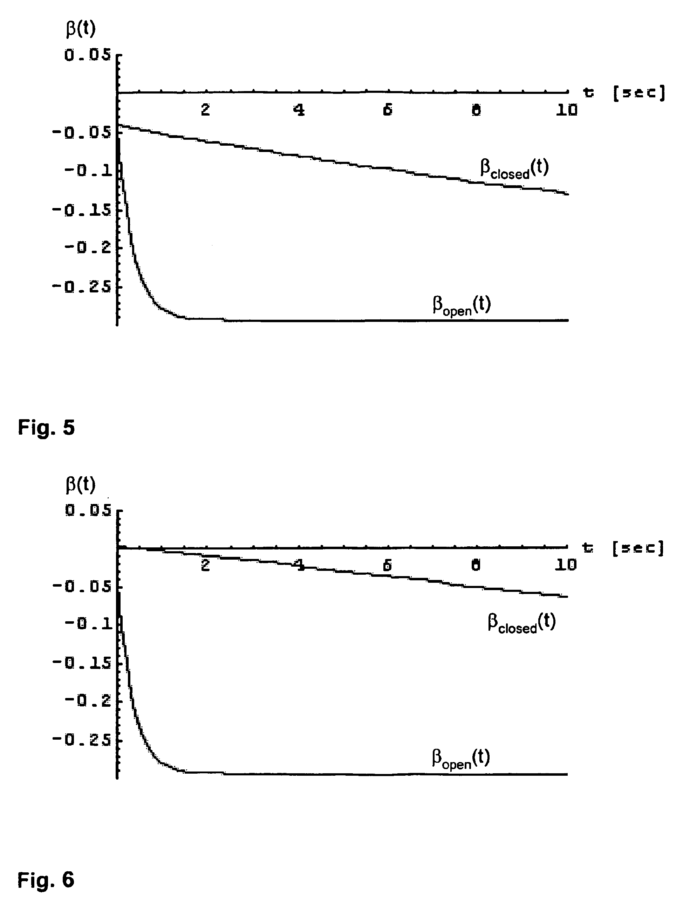

**Fig. 5** zeigt die berechnete Größe $\beta(t)$ einer erfindungsgemäßen Anordnung gemäß Fig. 3 und 4, einerseits mit offenen Kontakten K1, K2, K3 ($\beta_{open}(t)$), und andererseits mit zwei geschlossenen Kontakten K1 und K3 ($\beta_{closed}(t)$). Es ist $\beta_{closed}(t>0)$ betragsmäßig kleiner als $\beta_{open}(t>0)$, aber zur Zeit $t=0$ besteht kein Unterschied.

**Fig. 6** zeigt die berechnete Größe $\beta(t)$ einer erfindungsgemäßen Anordnung gemäß Fig. 3 und 4, einerseits mit offenen Kontakten K1, K2, K3 ($\beta_{open}(t)$), und andererseits mit drei geschlossenen Kontakten K1, K2, K3 ($\beta_{closed}(t)$). In diesem Beispiel ist auch zur Zeit $t=0$ $\beta_{closed}(t=0)$ betragsmäßig kleiner als $\beta_{open}(t=0)$.

$|\beta_{closed}| < |\beta_{open}|$ bedeutet, dass durch das Schließen der Kontakte die Fähigkeit der Magnetanordnung, die Auswirkungen einer Störung im magnetischen Umgebungsfeld auf das Feld im Arbeitsvolumen zu dämpfen, verbessert wird.

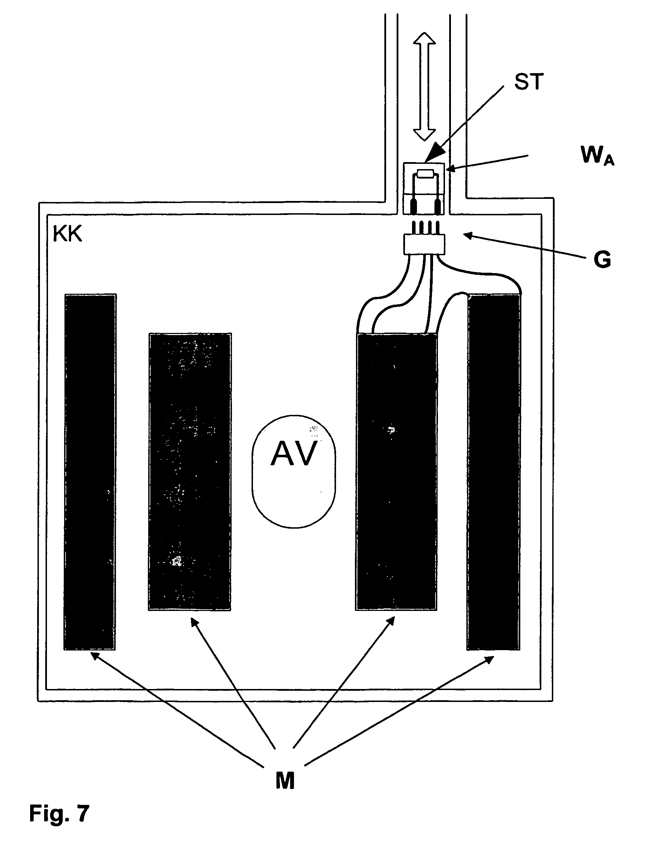

**Fig. 7** zeigt eine erfindungsgemäße Anordnung eines Magnetspulensystems mit einem Arbeitsvolumen AV, wobei ein Widerstandselement $W_{A1\text{-}A2}$ in einen Stecker ST integriert ist. Der Stecker ST kann im supraleitenden Zustand des Magnetspulensystems M durch Einstecken in seinen Gegenpol **G** verbunden und durch Ausstecken wieder entfernt werden und befindet sich in der gleichen kryogenen Kammer **KK** wie das Magnetspulensystem M.

Im Folgenden wird die Erfindung anhand von Beispielen erläutert. Ein erstes Beispiel bezieht sich auf eine Ausführungsform der Erfindung, bei welcher erfindungsgemäße kontaktierbare Widerstandselemente mit der Funktion von Schutzwiderständen in einer Magnetanordnung fest verdrahtete Schutzwiderstände ersetzen. Ein zweites Beispiel bezieht sich auf eine Magnetanordnung mit einer im Sinne der Erfindung zu- und abschaltbaren Driftkompensation. Im dritten Beispiel wird eine erfindungsgemäße Vorrichtung zur Kompensation von Störungen im magnetischen Hintergrundfeld der Magnetanordnung gezeigt.

Während des Ladens einer supraleitenden Magnetanordnung haben fest verdrahtete Schutzwiderstände, welche parallel zu den Spulenabschnitten geschaltet sind, den Nachteil, dass sie Energie dissipieren, was zu Verlusten an Kühlflüssigkeit führt. Schutzwiderstände haben nur die Funktion, während einem Zusammenbruch der Supraleitung (Quench), den Magneten vor übermäßigem Erhitzen und vor zu großen elektrischen Spannungen zu schützen. Solange aber die in der Magnetanordnung gespeicherte Energie nicht groß ist, ist ein solcher Schutz nicht notwendig. Werden nun beispielsweise beim Laden der Magnetanordnung erst bei 70% des Magnetstromes (50% der Energie) die als Schutzwiderstände dienende Widerstandselemente mit dem supraleitenden Strompfad kontaktiert, kann die in den Widerständen dissipierte Energie auf 30% reduziert werden, was hinsichtlich der Kühlflüssigkeitsverluste ein enormer Vorteil ist.

In der Patentanmeldung US 2002/0171520 A1 wird eine Magnetanordnung mit supraleitenden Zusatzschaltern beschrieben, welche zur Driftkompensation eingesetzt werden. Mit den aktiven Zusatzschaltern 25a und 25c (siehe Tabelle 1 Seite 8) kann eine besonders effiziente Kompensation der Drift erzielt werden. Es soll nun gezeigt werden, dass mit dem Einsatz von zuschaltbaren Widerstandselementen an Stelle von supraleitenden Schaltern mit geringerem Aufwand das gleiche Resultat erzielt werden kann, allerdings nur für eine begrenzte Zeitdauer.

Aus den Angaben der Patentanmeldung US 2002/0171520 A1 kann das Schaltschema der dortigen Figur 6 mit den Größen L1=1.929 H, L2=2.075 H, L3=185.314 H, M1=1.211 H, M2=13.840 H, M3= 7.975 H, R1=4.77*10$^{-13}$ Ω, R2=2.00*10$^{-11}$ Ω, R3=1.94*10$^{-9}$ Ω verwendet werden. Die Feldstärken der Spulen sind K1=0.0169 T/A, K2=0.0080 T/A und K3=0.0502 T/A im Arbeitsvolumen der Magnetanordnung. Aus den Formeln (12) und (13) berechnet sich die Drift mit den Zusatzschaltern zu 0.0015 ppm/h, was deutlich besser ist als die spezifizierten 0.01 ppm/h. Ohne den Einsatz der Zusatzschalter wäre die Drift -0.012 ppm/h.

Das Hantieren mit Zusatzschaltern ist jedoch sehr aufwändig, da nach Feststellung einer Drift der Magnet aufgewärmt und repariert werden muss. Auch müssen die Zusatzschalter während dem Laden der Magnetanordnung geheizt werden, wodurch zusätzliche Verluste an kryogener Flüssigkeit entstehen. Demgegenüber ist der erfindungsgemäße Einsatz von zuschaltbaren Widerstandselementen sehr einfach, da beispielsweise nur ein Stecker in seinen Gegenpol eingesteckt werden muss. Werden nun im obigen Beispiel die Zusatzschalter über L1 und L2 mit Kurzschlüssen von je 1 mΩ ersetzt, ergibt sich eine anfängliche Drift von 0.0015 ppm/h und die Drift bleibt während etwa einer Stunde besser als die spezifizierten 0.01 ppm/h. Eine solche Anordnung eignet sich also für Anwendungen, bei welchen Messungen, welche nicht länger als eine Stunde dauern, bei verschiedenen Feldstärken durchgeführt werden. Nach dem Setzen des Sollfeldes kann die Feldstärke im Arbeitsvolumen so mit einfachen Mitteln für die Messung ausreichend stabilisiert werden.

Im Folgenden wird noch ein Beispiel angegeben, in dem durch das Zuschalten von kleinen Widerstandselementen nach dem Laden einer Magnetanordnung ihr Verhalten gegenüber Schwankungen des Hintergrundfeldes wesentlich verbessert werden kann. Die dem Beispiel zu Grunde gelegte Ausführungsform der erfindungsgemäßen Anordnung ist jene aus den Fig. 3 und 4.

Auch wenn die Erfindung nicht nur Magnetsysteme mit einem im Arbeitsvolumen besonders homogenen Magnetfeld betrifft, sind solche besonders empfindlich auf Schwankungen des Hintergrundfeldes. Demnach soll hier ein Beispiel eines solchen Systems angegeben werden, in dem der Einsatz von zuschaltbaren Widerstandselementen ein verbessertes Störverhalten ermöglicht. In der nächsten Tabelle ist die Geometrie des Spulensystems angegeben.

In der Tabelle 1 bezeichnen (siehe Fig. 3):

*ri*    den Innenradius der Solenoidspule,

*ra*    den Außenradius der Solenoidspule,

*l*    die Länge der Solenoidspule,

*W*    die Anzahl Draht-Windungen auf jeder Lage der Solenoidspule,

*N*    die Anzahl Drahtlagen der Solenoidspule.

Tabelle 1

|  | Sektion 1 SE1 | Sektion 2 SE2 | Halfnotch HN |
|---|---|---|---|
| *ri* [Millimeter] | 40.0 | 56.0 | 63.8 |
| *ra* [Millimeter] | 49.2 | 69.4 | 66.1 |

(fortgesetzt)

|  | Sektion 1 SE1 | Sektion 2 SE2 | Halfnotch HN |
|---|---|---|---|
| *l* [Millimeter] | 382 | 379 | 141.2 |
| *W* | 510 | 590 | 220 |
| *N* | 14 | 24 | 4 |

Der Halfnotch HN ist ein Bereich halber Stromdichte in der Sektion SE2 und dient dazu, das Feld im Zentrum der Spulen möglichst homogen zu machen.

Die Sektionen SE1 und SE2 sind elektrisch in Serie geschaltet und supraleitend kurzgeschlossen. Parallel zur Sektion SE1 ist, wie in der Fig. 4 abgebildet, ein Schutzelement R1 von 1 Ohm und parallel zur Sektion SE2 ein Schutzelement R2 von 2 Ohm fest mit dem supraleitenden Strompfad P verbunden.

Um das Verhalten dieser Magnetanordnung bezüglich Schwankungen des Hintergrundfeldes zu untersuchen, soll eine Störschlaufe mit 2 Meter Durchmesser herangezogen werden. Diese Schlaufe soll konzentrisch zu den Sektionen SE1, SE2 angeordnet sein und auf Höhe des Zentrums der Solenoidspulen liegen. Es soll zur Zeit *t=0* ein Strom von 10 Ampere in diese Schlaufe eingefahren werden. Der Einfachheit halber wird der zeitliche Verlauf des Stromes als stufenförmig angenommen.

Bevor die zeitliche Entwicklung der in den supraleitenden Magnetspulen des Magnetspulensystems M induzierten Ströme berechnet werden kann, muss die Notation für die wichtigsten Größen der Magnetanordnung festgelegt werden: $L = \begin{pmatrix} 0.884 & 1.74 \\ 1.74 & 6.18 \end{pmatrix} [\text{Henry}]$: Induktivitätsmatrix aufgelöst nach den Sektionen SE1 und SE2,

$I = \begin{pmatrix} I_1 \\ I_2 \end{pmatrix}$: Ströme aufgelöst nach den Sektionen SE1 und SE2,

$b = (229 \ 417)$ [Gauss/A]: Feld pro Ampere der Sektionen SE1 und SE2 im Zentrum der Magnetanordnung,

$L_{coupling} = \begin{pmatrix} 27.6 \\ 105 \end{pmatrix} [\mu\text{Henry}]$: induktive Kopplung der Störschlaufe mit den Sektionen SE1 und SE2,

$\Delta I_{pert} = 10$ [A]: Stromänderung in der Störschlaufe,

$b_{pert} = 0.00628$ [Gauss/A]: Feld pro Ampere der Störschlaufe im Zentrum der Magnetanordnung,

$\Delta B_z = b_{perl} * \Delta I_{pert} = 0.0628$ [Gauss]: Änderung des Hintergrundfeldes,

$R_1 = 1$ [$\Omega$], $R_2 = 2$ [$\Omega$]: Schutzwiderstände parallel zu den Sektionen SE1 und SE2.

Nach der Lenz'schen Regel reagiert jede Sektion der betrachteten Magnetanordnung zur Zeit *t=0* mit einer eigenen Stromänderung $\Delta I_1$, $\Delta I_2$ auf die Feldstörung. Diese Stromänderungen sind so groß, dass der magnetische Fluss durch jede Sektion unverändert bleibt. Genauer gesagt gilt:

$$L\Delta I = -L_{coupling}\Delta I_{pert}$$

oder

$$\Delta I = -L^{-1}L_{coupling}\Delta I_{pert} = \begin{pmatrix} 49.8 \\ -184 \end{pmatrix} [\mu A].$$

Da nur Stromänderungen in den Sektionen SE1 und SE2 angeschaut werden, werden die Ströme $I_1$ und $I_2$ für *t<0* gleich null gesetzt, so dass die Ströme zur Zeit t=0 gleich $\Delta I_1$, $\Delta I_2$ sind:

$$I(t=0) = \begin{pmatrix} 49.8 \\ -184 \end{pmatrix} [\mu A]$$

Multipliziert man diese Ströme mit der entsprechenden Feldstärke b der Sektionen SE1, SE2, bekommt man den Feldbeitrag der Sektionen SE1, SE2 im Zentrum der Magnetanordnung. Die gesamte Feldänderung im Zentrum der Magnetanordnung ist die additive Überlagerung des Beitrages der Sektionen SE1, SE2 und des Beitrages der Störschlaufe:

$$b \cdot I(t=0) + \Delta B_z = 0.0114\text{-}0.0767\text{+}0.0628 = -2.5 \times 10^{-7}T \left( 0.0025\,[\text{Gauss}] \right)$$

Betrachtet man diese Feldänderung im Verhältnis zur Schwankung des Hintergrundfeldes $\Delta B_z$, bekommt man die dimensionslose Größe

$$\beta(t=0) = 1 + \frac{b \cdot I(t=0)}{\Delta B_z} = -0.040$$

Dank der Abschirmströme in den Sektionen SE1, SE2, gelangt zur Zeit *t=0* also nur -4 % der Hintergrundfeldschwankung ins Zentrum der Magnetanordnung. Das negative Vorzeichen bedeutet, dass die Richtung des Feldvektors der Störung im Arbeitsvolumen AV gekehrt wird, die Störung wird also durch das Magnetspulensystem M überkompensiert. Wenn man lange genug wartet, baut sich der Differenzstrom zwischen den Sektionen SE1 und SE2 ab, und es fließt nur noch ein einziger Strom durch beide Sektionen SE1, SE2. Die Größe dieses Stromes bekommt man, indem man in der obigen Berechnung alle Vektoren und Matrizen durch die Summe ihrer Einträge ersetzt. Bezeichnet man die neuen eindimensionalen Größen mit einer Tilde, lauten die Resultate:

$$\tilde{I}(t=\infty) = -\tilde{L}^{-1}\tilde{L}_{coupling}\Delta I_{pert} = -10.5^{-1} * 132.6 * 10^{-6} * 10[\text{A}] = -126\,[\mu\text{A}]$$

$$\tilde{b} \cdot \tilde{I}(t=\infty) + \Delta B_z = -0.0814\text{+}0.0628 = -0.0186\,[\text{Gauss}]$$

$$\beta(t=\infty) = 1 + \frac{\tilde{b} \cdot \tilde{I}(t=0)}{\Delta B_z} = -0.30$$

Nach langer Zeit dringt also ca. -30 % der Störung ins Zentrum der Magnetanordnung ein. Entscheidend für das Störverhalten der Magnetanordnung ist nun insbesondere, wie schnell die Störung eindringt. Für Zeiten *t>0* gehorchen die Ströme dem Differentialgleichungssystem

$$L\frac{dI}{dt} = -R \cdot I$$

mit der Widerstandsmatrix

$$R = \begin{pmatrix} R_1 - R_1 s_1 & -R_1 s_2 \\ -R_2 s_1 & R_2 - R_2 s_2 \end{pmatrix}$$

wobei

$$s_1 = \frac{R_1}{R_1 + R_2} \;,\; s_2 = \frac{R_2}{R_1 + R_2}$$

Das Differentialgleichungssystem hat eine Exponentialfunktion als Lösung. Die charakteristische Zeitkonstante $\tau$ ist der Kehrwert des größeren Eigenwertes der Matrix

$$L^{-1}R = \begin{pmatrix} 2.17 & 0.718 \\ -2.17 & -0.718 \end{pmatrix}[\text{Hz}]$$

während der kleinere Eigenwert der Matrix null ist (die beiden Sektionen sind supraleitend kurzgeschlossen). Man bekommt

$$\tau = 0.35\ [\text{sec}]$$

Der große Vorteil, dass die Störung zur Zeit $t=0$ gut unterdrückt wird, kommt also kaum zur Geltung, da nach weniger als 1 [sec] bereits fast -30 % des Hintergrundfeldes $\Delta B_z$ das Zentrum der Magnetanordnung erreicht hat.
Die Situation verbessert sich, wenn die Sektion SE2 mit einem Widerstand $W_{A1-A3}$ von 10 [mΩ] überbrückt wird. Man bekommt nämlich die Zeitkonstante

$$\tau = 23\ [\text{sec}]$$

Die Schwankung des Hintergrundfeldes $\Delta B_z$ kann nun nur noch sehr langsam das Zentrum der Magnetanordnung erreichen (Fig. 5).
Eine weitere Verbesserung wird erreicht, wenn die letzten 10 Lagen der Sektion SE2 mit einem Widerstand $W_{A2-A3}$ von 10 [mΩ] überbrückt werden. Durch die feinere Unterteilung der Magnetspulen reduziert sich $\beta(t=0)$ auf 0.2 %. Die Zeitkonstante liegt mit beiden Widerständen von 10 [mΩ] bei $\tau = 33$ [sec] (Fig.6).
Widerstandselemente mit Widerstandswerten in der Größenordnung von Milliohm können nicht fest mit dem supraleitenden Strompfad kontaktiert werden, weil dies beim Laden und Entladen der Magnetspulen zu großen Verlusten von Kühlflüssigkeit führen würde, und weil sich nach dem Lade- oder Entladevorgang nur sehr langsam ein Gleichgewichtszustand der Ströme in den überbrückten Spulenabschnitten einstellen könnte. Der Vorteil von Elementen mit so tiefen Widerstandswerten hinsichtlich Kompensation von Magnetfeldstörungen kann daher erst genutzt werden, wenn die Elemente während des Betriebs der Magnetanordnung zu- und wieder weggeschaltet werden können, wie es die vorliegende Erfindung vorsieht. Ebenso können Widerstandselemente in der erfindungsgemäßen Art und Weise als zuschaltbare Schutzwiderstände mit entsprechend höheren Widerstandswerten (ca. 1Ohm) vorgesehen sein

**Bezugszeichenliste**

| | |
|---|---|
| A1, A2, A3, A4, A5 | Anschlusspunkte |
| AV | Arbeitsvolumen |
| G | Gegenpol des Steckers ST |
| HN | Halfnotch |
| K1, K2, K3, K4 | Kontakte |
| KK | kryogene Kammer |
| M | Magnetspulensystem |
| P | supraleitender Strompfad |
| $P_{A1-A2}$, $P_{A2-A3}$, $P_{A3-A4}$ | Abschnitte |
| R1, R2 | Schutzelemente |
| S1, S2, S3, S4 | Schalter |
| SE1, SE2 | Sektionen des Magnetspulensystems |
| SE2L1-14, SE2LO15-24 | Spulenabschnitte der Sektion SE2 |
| ST | Stecker |
| $W_{A1-A2}$, $W_{A2-A3}$, $W_{A3-A4}$, $W_{A1-A3}$ | Widerstandselemente |

**Patentansprüche**

1. Magnetanordnung mit einem supraleitenden Magnetspulensystem (M) und einem mindestens teilweise supraleitenden Strompfad (P), welcher mindestens Teile des Magnetspulensystems (M) umfasst, wobei auf dem Strompfad (P) mindestens zwei elektrische Anschlusspunkte (A1, A2, A3, A4) angebracht sind, welche innerhalb des Strompfades (P) mindestens einen Abschnitt ($P_{A1-A2}$, $P_{A2-A3}$, $P_{A3-A4}$) begrenzen, so dass jeder Abschnitt von zwei aufeinanderfolgenden Anschlusspunkten begrenzt ist, wobei der Abschnitt ($P_{A1-A2}$, $P_{A2-A3}$, $P_{A3-A4}$) nicht die Gesamtheit der im Strompfad (P) enthaltenen Teile des Magnetspulensystems (M) umfasst,
mit mindestens einem fest verdrahteten Schutzelement (R1, R2), welches einen oder mehrere der Abschnitte ($P_{A1-A2}$, $P_{A2-A3}$, $P_{A3-A4}$) parallel überbrückt und als Quenchschutz dient,
wobei das supraleitende Magnetspulensystem (M) im Betriebszustand ein Magnetfeld in Richtung einer z-Achse in einem auf der z-Achse um z = 0 angeordneten Arbeitsvolumen (AV) erzeugt, und
wobei zur Kompensation von Magnetfeldstörungen mindestens ein Widerstandselement ($W_{A1-A2}$, $W_{A2-A3}$, $W_{A3-A4}$) mit einem elektrischen Widerstandswert größer oder gleich null einen oder mehrere der Abschnitte ($P_{A1-A2}$, $P_{A2-A3}$, $P_{A3-A4}$) überbrückt, und
**dadurch gekennzeichnet,**
**dass** mindestens zwei elektrische Kontakte (K1, K2, K3, K4), die im supraleitenden Zustand des Magnetspulensystems geschlossen und geöffnet werden können, vorgesehen sind, wobei jeweils ein elektrischer Kontakt (K1, K2, K3) auf einer Seite und ein elektrischer Kontakt (K2, K3, K4) auf der anderen Seite bezüglich jedes Widerstandselements ($W_{A1-A2}$, $W_{A2-A3}$, $W_{A3-A4}$) zwischen dem Widerstandselement ($W_{A1-A2}$, $W_{A2-A3}$, $W_{A3-A4}$) und jeweils einem der mindestens zwei elektrischen Anschlusspunkte (A1, A2, A3, A4) angeordnet ist, und
**dass** mindestens zwei der Anschlusspunkte (A1, A2, A3, A4) innerhalb des Strompfades (P) derart angeordnet sind, dass für die

$$\text{Größe } \beta(t) = 1 + \frac{b \cdot \Delta I(t)}{\Delta B_z}$$

.

im Falle von mindestens zwei geschlossenen Kontakten (K1, K2, K3, K4) zur Zeit $t$=0 ein Wert $\beta_{closed}(t = 0)$ resultiert, welcher im Betrag kleiner ist als die Größe $\beta_{open}(t = 0)$, welche zur Zeit $t=0$ und bei offenen Kontakten (K1, K2, K3, K4) resultiert, mit
b: Vektor der Magnetfelder in Richtung der z-Achse jeder Windung des Magnetspulensystems (M) im Arbeitsvolumen (AV) für jeweils 1 Ampere Strom,
$\Delta I(t)$: Vektor der Stromänderungen jeder Windung des Magnetspulensystems (M), welche durch eine Änderung $\Delta B_z$ des Magnetfeldes induziert werden, wobei $\Delta B_z$ die Komponente parallel zur z-Achse einer stufenförmigen Änderung des Magnetfeldhintergrundes im Zentrum der Magnetanordnung zur Zeit $t=0$ bedeutet.

2. Magnetanordnung nach Anspruch 1, **dadurch gekennzeichnet, dass** die Widerstandselemente ($W_{A1-A2}$, $W_{A2-A3}$, $W_{A3-A4}$) so dimensioniert sind, dass im Falle von mindestens zwei geschlossenen Kontakten (K1, K2, K3, K4) für alle Zeiten $t$ der Wert $\beta_{closed}(t)$ im Betrag kleiner als oder gleich wie die Größe $\beta_{open}(t)$, welche bei offenen Kontakten (K1, K2, K3, K4) resultiert.

3. Magnetanordnung nach einem der vorhergehenden Ansprüche, **dadurch gekennzeichnet, dass** die Widerstandselemente (W$_{A1-A2}$, W$_{A2-A3}$, W$_{A3-A4}$) mit dem supraleitenden Magnetspulensystem (M) gemeinsam in einer gekühlten Kammer (KK) angeordnet sind.

4. Magnetanordnung nach einem der vorhergehenden Ansprüche, **dadurch gekennzeichnet, dass** mindestens eines der fest verdrahtetes Schutzelement (R1, R2) ohmsche Widerstandselemente oder Dioden, oder eine Kombination von beiden umfasst.

5. Magnetanordnung nach einem der vorhergehenden Ansprüche, **dadurch gekennzeichnet, dass** die Widerstandselemente (W$_{A1-A2}$, W$_{A2-A3}$, W$_{A3-A4}$) einen Widerstandswert aufweisen, der kleiner als der Widerstandswert der Schutzelemente (R1, R2) ist.

6. Magnetanordnung nach einem der vorhergehenden Ansprüche, **dadurch gekennzeichnet, dass** die Widerstandselemente (W$_{A1-A2}$, W$_{A2-A3}$, W$_{A3-A4}$) Teil eines Steckers (ST) sind, und dass die Widerstandselemente (W$_{A1-A2}$, W$_{A2-A3}$, W$_{A3-A4}$) durch Schließen der Kontakte (K1, K2, K3, K4) mittels Einstecken des Steckers (ST) in seinen Gegenpol, aus dem die Anschlusspunkte (A1, A2, A3, A4) herausgeführt sind, mit den Anschlusspunkten (A1, A2, A3, A4) verbunden werden können..

7. Magnetanordnung nach einem der Ansprüche 1 bis 5, **dadurch gekennzeichnet, dass** die Widerstandselemente (W$_{A1-A2}$, W$_{A2-A3}$, W$_{A3-A4}$) durch Schließen der Kontakte mittels Betätigen mindestens eines Schalters (S1, S2, S3, S4) mit den Anschlusspunkten (A1, A2, A3, A4) verbunden werden können.

8. Magnetanordnung nach einem der vorangehenden Ansprüche, **dadurch gekennzeichnet, dass** die Widerstandselemente (W$_{A1-A2,}$ W$_{A2-A3}$, W$_{A3-A4}$) mit zunehmendem Strom einen zunehmenden Widerstandswert aufweisen.

9. Magnetanordnung nach einem der vorhergehenden Ansprüche, **dadurch gekennzeichnet, dass** die Widerstandselemente (W$_{A1-A2,}$ W$_{A2-A3}$, W$_{A3-A4}$) im Falle eines Quenchs des supraleitenden Magnetspulensystems (M) hochohmig werden, insbesondere einen Widerstandswert von mehr als 10 Ohm annehmen, und dass das mindestens eine fest verdrahteten Schutzelement (R1, R2) den Schutz des Magnetspulensystems (M) sicherstellt.

10. Magnetanordnung nach einem der vorangehenden Ansprüche, **dadurch gekennzeichnet, dass** die Widerstandselemente (W$_{A1-A2,}$ W$_{A2-A3,}$ W$_{A3-A4}$) Sicherungselemente sind, die höchstens 20% des Magnetstromes tragen können, bevor sie durchbrennen und hochohmig werden, und dann einen Widerstandswert von mehr als 10 Ohm annehmen.

11. Verfahren zum Betrieb einer Magnetanordnung nach einem der vorangehenden Ansprüche, **dadurch gekennzeichnet, dass** mindestens ein elektrischer Kontakt (K1, K2, K3, K4) zwischen mindestens einem elektrischen Anschlusspunkt (A1, A2, A3, A4) und mindestens einem Widerstandselement (W$_{A1-A2}$, W$_{A2-A3}$, W$_{A3-A4}$) im Betriebszustand des Magnetspulensystems (M) geschlossen und beim Laden und Entladen des Magnetspulensystems (M) geöffnet wird.

**Claims**

1. Magnet configuration comprising
a superconducting magnet coil system (M) and a current path (P) which is at least partially superconducting and comprises at least parts of the magnet coil system (M), wherein at least two electric connecting points (A1, A2, A3, A4) are disposed on the current path (P), which define at least one section (P$_{A1-A2}$, P$_{A2-A3}$, P$_{A3-A4}$) within the current path (P) such that each section is defined by two successive connecting points, wherein the section (P$_{A1-A2}$, P$_{A2-A3}$, P$_{A3-A4}$) does not comprise all parts of the magnet coil system (M) contained in the current path (P),
at least one permanently wired protective element (R1, R2) which bridges one or more of the sections (P$_{A1-A2}$, P$_{A2-A3}$, P$_{A3-A4}$) in parallel and serves as quench protection,
wherein the superconducting magnet coil system (M) generates a magnetic field in the direction of a z axis in a working volume (AV) disposed about z=0 on the z axis during operation, and
wherein for compensating for magnetic field disturbances, at least one resistive element (W$_{A1-A2}$, W$_{A2-A3}$, W$_{A3-A4}$)

having an electrical resistance value $\geq 0$ bridges one or more of the sections ($P_{A1-A2}$, $P_{A2-A3}$, $P_{A3-A4}$), and

**characterized in that**

at least two electric contacts (K1, K2, K3, K4), which can be closed and opened in the superconducting state of the magnet coil system, are provided, wherein one electric contact (K1, K2, K3) is disposed on one side and one electric contact (K2, K3, K4) is disposed on the other side with respect to each resistive element ($W_{A1-A2}$, $W_{A2-A3}$, $W_{A3-A4}$) between the resistive element ($W_{A1-A2}$, $W_{A2-A3}$, $W_{A3-A4}$) and one of the at least two electric connecting points (A1, A2, A3, A4), and

at least two of the connecting points (A1, A2, A3, A4) are disposed in the current path (P) in such a manner that the

value $\beta(t) = 1 + \dfrac{b \cdot \Delta I(t)}{\Delta B_z}$ results in a value $\beta_{closed}(t=0)$ when at least two contacts (K1, K2, K3, K4) are closed at a time *t=0*, whose amount is smaller than the value $\beta_{open}(t=0)$, which results at a time *t=0* with open contacts (K1, K2, K3, K4),

with

b: vector of the magnetic fields in the direction of the z axis of each winding of the magnet coil system (M) in the working volume (AV) for 1 ampere current each,

$\Delta I(t)$: vector of the current changes of each winding of the magnet coil system (M) which are induced by a change $\Delta B_z$ in the magnetic field, wherein $\Delta B_z$ is the component parallel to the z axis of a stepped change in the background magnetic field in the center of the magnet configuration at a time *t=0*.

2. Magnet configuration according to claim 1, **characterized in that** the resistive elements ($W_{A1-A2}$, $W_{A2-A3}$, $W_{A3-A4}$) are dimensioned such that, in case of at least two closed contacts (K1, K2, K3, K4), the value $\beta_{closed}(t)$ for all times t is smaller or equal to the value $\beta_{open}(t)$ which results with open contacts (K1, K2, K3, K4).

3. Magnet configuration according to any one of the preceding claims, **characterized in that** the resistive elements ($W_{A1-A2}$, $W_{A2-A3}$, $W_{A3-A4}$) are disposed in a cooled chamber (KK) together with the superconducting magnet coil system (M).

4. Magnet configuration according to any one of the preceding claims, **characterized in that** at least one of the permanently wired protective elements (R1, R2) comprises ohmic resistive elements or diodes or a combination of both.

5. Magnet configuration according to any one of the preceding claims, **characterized in that** the resistive elements ($W_{A1-A2}$, $W_{A2-A3}$, $W_{A3-A4}$) have a resistance value, which is smaller than the resistance value of the protective elements (R1, R2).

6. Magnet configuration according to any one of the preceding claims, **characterized in that** the resistive elements ($W_{A1-A2}$, $W_{A2-A3}$, $W_{A3-A4}$) are part of a plug (ST), and the resistive elements ($W_{A1-A2}$, $W_{A2-A3}$, $W_{A3-A4}$) can be connected to the connecting points (A1, A2, A3, A4) through closing the contacts (K1, K2, K3, K4) by inserting the plug (ST) into its counter pole from which the connecting points (A1, A2, A3, A4) extend.

7. Magnet configuration according to any one of the claims 1 through 5, **characterized in that** the resistive elements ($W_{A1-A2}$, $W_{A2-A3}$, $W_{A3-A4}$) can be connected to the connecting points (A1, A2, A3, A4) by closing the contacts through operating at least one switch (S1, S2, S3,S4).

8. Magnet configuration according to any one of the preceding claims, **characterized in that** the resistive elements ($W_{A1-A2}$, $W_{A2-A3}$, $W_{A3-A4}$) have an increasing resistance value with increasing current.

9. Magnet configuration according to any one of the preceding claims, **characterized in that** the resistive elements ($W_{A1-A2}$, $W_{A2-A3}$, $W_{A3-A4}$) assume a high ohmic value in case of a quench of the superconducting magnet coil system (M), in particular, a resistance value of more than 10 ohms, and the at least one permanently wired protective element (R1, R2) ensures protection of the magnet coil system (M).

10. Magnet configuration according to any one of the preceding claims, **characterized in that** the resistive elements ($W_{A1-A2}$, $W_{A2-A3}$, $W_{A3-A4}$) are safety elements, which can carry at most 20% of the magnetic current before they burn and assume a high ohmic value, i.e. a resistance value of more than 10 ohms.

**11.** Method for operating a magnet configuration according to any one of the preceding claims, **characterized in that** at least one electric contact (K1, K2, K3, K4) between at least one electric connecting point (A1, A2, A3, A4) and at least one resistive element ($W_{A1-A2}$, $W_{A2-A3}$, $W_{A3-A4}$) is closed during operation of the magnet coil system (M) and opened during charging and discharging of the magnet coil system (M).

## Revendications

**1.** Dispositif magnétique avec un système de bobines magnétiques supraconductrices (M) et un circuit de courant (P) au moins partiellement supraconducteur, lequel comprend au moins des parties du système de bobines magnétiques (M), sur lequel circuit de courant (P) sont disposés au moins deux points de connexion électrique (A1, A2, A3, A4), lesquels délimitent à l'intérieur du circuit de courant (P) au moins une portion ($P_{A1-A2}$, $P_{A2-A3}$, $P_{A3-A4}$), de façon que chaque portion soit limitée par deux points de connexion successifs, la portion ($P_{A1-A2}$, $P_{A2-A3}$, $P_{A3-A4}$) ne comprenant pas la totalité des parties du système de bobines magnétiques (M) contenues dans le circuit de courant (P),
avec au moins un élément de protection solidairement câblé (R1, R2), lequel court-circuite en parallèle une ou plusieurs des portions ($P_{A1-A2}$, $P_{A2-A3}$, $P_{A3-A4}$) et sert de protection contre le "quench", c'est-à-dire une perte de l'état supraconducteur,
le système de bobines magnétiques (M) produisant, dans l'état de fonctionnement, un champ magnétique en direction d'un axe z dans un volume de travail (AV) disposé sur l'axe z autour de z = 0, et
au moins un élément résistant ou résistif ($W_{A1-A2}$, $W_{A2-A3}$, $W_{A3-A4}$) ayant une valeur de résistance électrique supérieure ou égale à zéro court-circuitant une ou plusieurs des portions ($P_{A1-A2}$, $P_{A2-A3}$, $P_{A3-A4}$) pour compenser les perturbations de champ magnétique,
**caractérisé en ce**
**qu'**il est prévu au moins deux contacts électriques (K1, K2, K3, K4) qui sont fermés dans l'état supraconducteur du système de bobines magnétiques et qui peuvent être ouverts, un contact électrique (K1, K2, K3) étant disposé d'un côté et un contact électrique (K2, K3, K4) de l'autre côté par rapport à chaque élément résistant ($W_{A1-A2}$, $W_{A2-A3}$, $W_{A3-A4}$) entre l'élément résistant ($W_{A1-A2}$, $W_{A2-A3}$, $W_{A3-A4}$) et chaque fois un desdits au moins deux points de connexion électrique (A1, A2, A3, A4), et
**qu'**au moins deux des points de connexion (A1, A2, A3, A4) sont disposés dans le circuit de courant (P) de façon que pour la grandeur $\beta(t) = 1 + \dfrac{b \cdot \Delta I(t)}{\Delta B_z}$

dans le cas d'au moins deux contacts (K1, K2, K3, K4) fermés au temps t = 0, il en résulte une valeur $\beta_{closed}(t = 0)$, laquelle est inférieure en valeur absolue à la valeur $\beta_{open}(t = 0)$ obtenue au temps t = 0 avec les contacts (K1, K2, K3, K4) ouverts, avec :

    b : vecteur des champs magnétiques en direction de l'axe z de chaque spire du système de bobines magnétiques (M) dans le volume de travail (AV) pour chaque fois 1 ampère de courant,
$\Delta I(t)$ : vecteur des variations de courant de chaque spire du système de bobines magnétiques (M), lesquelles sont induites par une variation $\Delta B_z$ du champ magnétique, $\Delta B_z$ représentant la composante parallèlement à l'axe z d'une variation en gradins de l'arrière-plan magnétique au centre du dispositif magnétique au temps t = 0.

**2.** Dispositif magnétique selon la revendication 1, **caractérisé en ce que** les éléments résistants ($W_{A1-A2}$, $W_{A2-A3}$, $W_{A3-A4}$) sont dimensionnés de façon que, dans le cas d'au moins deux contacts (K1, K2, K3, K4) fermés, pour tous les temps *t* la valeur $\beta_{closed}(t)$ soit inférieure ou égale en valeur absolue à la valeur $\beta_{open}(t)$ obtenue avec les contacts (K1, K2, K3, K4) ouverts.

**3.** Dispositif magnétique selon une des revendications précédentes, **caractérisé en ce que** les éléments résistants ($W_{A1-A2}$, $W_{A2-A3}$, $W_{A3-A4}$) sont disposés en commun avec le système de bobines magnétiques (M) dans une chambre refroidie (KK).

**4.** Dispositif magnétique selon une des revendications précédentes, **caractérisé en ce qu'**au moins un élément de protection câblé (R1, R2) comprend des éléments résistants ohmiques ou des diodes, ou une combinaison des deux.

**5.** Dispositif magnétique selon une des revendications précédentes, **caractérisé en ce que** les éléments résistants ($W_{A1-A2}$, $W_{A2-A3}$, $W_{A3-A4}$) présentent une valeur de résistance qui est inférieure à la valeur de résistance des éléments de protection (R1, R2).

6. Dispositif magnétique selon une des revendications précédentes, **caractérisé en ce que** les éléments résistants ($W_{A1-A2}$, $W_{A2-A3}$, $W_{A3-A4}$) font partie d'une fiche (ST) et que les éléments résistants ($W_{A1-A2}$, $W_{A2-A3}$, $W_{A3-A4}$) peuvent être reliés aux points de connexion (A1, A2, A3, A4) par fermeture des contacts (K1, K2, K3, K4) en enfichant la fiche (ST) dans son pôle opposé à partir duquel les points de connexion (A1, A2, A3, A4) sont conduits à l'extérieur.

7. Dispositif magnétique selon une des revendications 1 à 5, **caractérisé en ce que** les éléments résistants ($W_{A1-A2}$, $W_{A2-A3}$, $W_{A3-A4}$) peuvent être reliés aux points de connexion (A1, A2, A3, A4) par fermeture des contacts (K1, K2, K3, K4) en actionnant au moins un commutateur (S1, S2, S3, S4).

8. Dispositif magnétique selon une des revendications précédentes, **caractérisé en ce que** les éléments résistants ($W_{A1-A2}$, $W_{A2-A3}$, $W_{A3-A4}$) présentent une valeur de résistance croissante quand le courant croît.

9. Dispositif magnétique selon une des revendications précédentes, **caractérisé en ce que** les éléments résistants ($W_{A1-A2}$, $W_{A2-A3}$, $W_{A3-A4}$) deviennent fortement résistants en cas de quench du système de bobines magnétiques (M), en particulier prennent une valeur de résistance supérieure à 10 ohms, et que ledit au moins un élément de protection câblé (R1, R2) assure la protection du système de bobines magnétiques (M).

10. Dispositif magnétique selon une des revendications précédentes, **caractérisé en ce que** les éléments résistants ($W_{A1-A2}$, $W_{A2-A3}$, $W_{A3-A4}$) sont des éléments fusibles qui peuvent supporter au maximum 20 % du courant de l'aimant avant de sauter et de devenir fortement résistants en prenant alors une valeur de résistance supérieure à 10 ohms.

11. Procédé pour faire fonctionner un dispositif magnétique selon une des revendications précédentes, **caractérisé en ce qu'**au moins un contact électrique (K1, K2, K3, K4) entre au moins un point de connexion électrique (A1, A2, A3, A4) et au moins un élément résistant ($W_{A1-A2}$, $W_{A2-A3}$, $W_{A3-A4}$) est fermé dans l'état de fonctionnement du système de bobines magnétiques (M) et ouvert lors de la charge et de la décharge du système de bobines magnétiques (M).

**Fig. 1**

**Fig. 2**

**Fig. 3**

**Fig. 4**

**Fig. 5**

**Fig. 6**

**Fig. 7**

**EP 1 757 950 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6307370 B
- JP 59121902 A
- US 6369464 B
- US 6777938 B
- JP 60189206 A
- JP 2000077226 A
- DE 10241966 A
- US 20020171520 A1